# FASCICULE DE BREVET EUROPEEN

(11) **EP 0 798 856 B1**
(45) Date de publication et mention de la délivrance du brevet: **24.06.1998**
(21) Numéro de dépôt: 97400723.9
(22) Date de dépôt: 28.03.1997
(51) Int. Cl.: H03K 7/08

(54) **Circuit de production d'impulsions avec répétition d'adresses**
Impulsgeneratorschaltung mit Adressen-Wiederholung
Pulse generator circuit with address repetition

(30) Priorité: 29.03.1996 FR 9604015
(43) Date de publication de la demande: 01.10.1997
(73) Titulaire: SGS-THOMSON MICROELECTRONICS S.A., 94250 Gentilly (FR)
(72) Inventeur: Bildgen, Marco, 75116 Paris (FR); Teissier, Maxime, 75116 Paris (FR)
(74) Mandataire: Schmit, Christian Norbert Marie

(56) Documents cités:
- EP-A- 0 283 952
- EP-A- 0 312 192
- US-A- 4 603 425
- US-A- 5 060 179
- 1990 IEEE INDUSTRY APPLICATIONS SOCIETY ANNUAL MEETING, vol. 2, 7 Octobre 1990, SEATTLE,US, pages 997-1004, XP000203419 G. JOOS ET. AL.: "A THREE PHASE MODEL REFERENCE ADAPTIVE PWM TECHNIQUE WITH IMPROVED FEATURES"

## Description

La présente invention a pour objet un circuit de production d'impulsions, et plus particulièrement d'impulsions modulées en largeur. L'invention est particulièrement utilisable dans le domaine de la commande des moteurs électriques et, parmi les moteurs commandables, plus particulièrement encore pour la commande des moteurs synchrones ou asynchrones triphasés. L'invention sera décrite dans le cadre préféré d'une telle utilisation pour en montrer toutes les applications. Cependant, la portée de l'invention ne peut être cantonnée aux impulsions modulées en largeur, le principe fondamental de l'invention consistant, avec des moyens limités, à réaliser un signal cyclique impulsionnel de fréquence variable.

Dans le domaine industriel on connaît de nombreuses utilisation de moteurs synchrones ou asynchrones triphasés: par exemple il s'agit de moteurs de pompes. Dans le domaine domestique on a déjà commencé à équiper les appareils ménagers de moteurs triphasés. En effet, ces moteurs présentent l'avantage de ne pas nécessiter de commutation et donc de ne pas être sujets à des usures de balais.

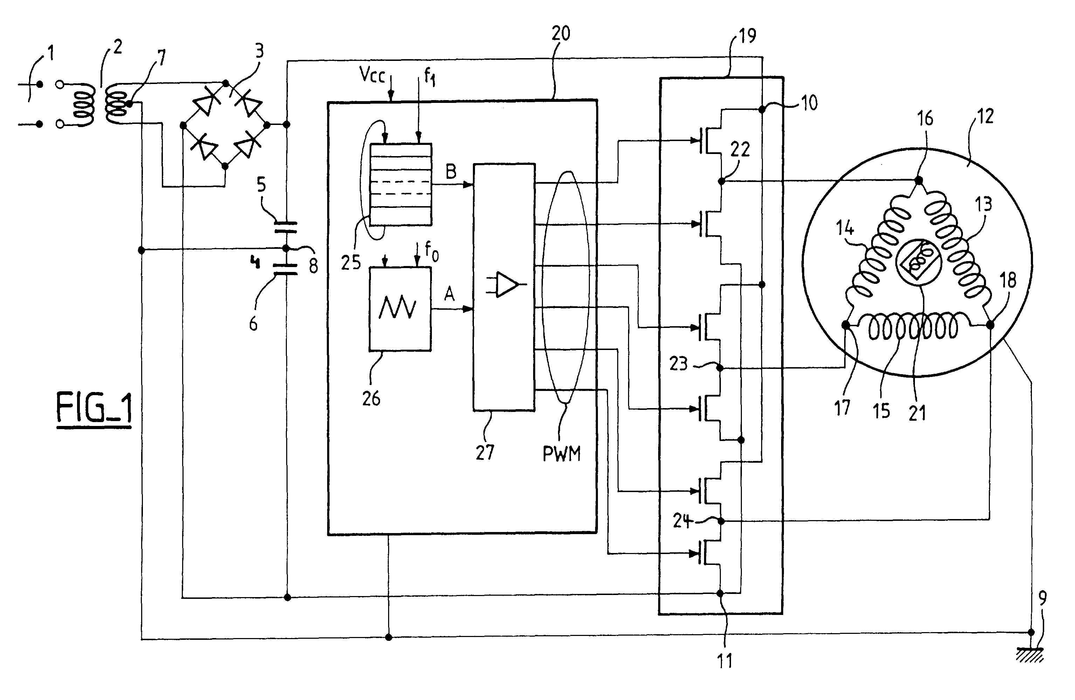

Dans le domaine domestique, ainsi que parfois dans le domaine industriel, de telles solutions n'étaient cependant pas utilisables parce qu'on ne disposait pas du courant électrique secteur sous une forme triphasée. Il a donc été imaginé des circuits électroniques de production de courant électrique triphasé à partir du secteur alternatif monophasé redressé. La figure 1 montre, à titre d'exemple, une telle utilisation.

Une alimentation secteur à courant alternatif monophasé 1 débite dans un transformateur 2 relié à un pont redresseur 3 double alternance à diodes. Le pont redresseur 3 est connecté en parallèle aux bornes d'un circuit capacitif 4 comportant dans l'exemple deux condensateurs 5 et 6 et fournissant une haute tension continue. Dans un exemple, cette haute tension continue est de l'ordre de 400 volts. Un point milieu 7 du transformateur 2 est relié à un point milieu 8 des condensateurs 5 et 6. Si on veut économiser un des condensateurs 5 ou 6 le point milieu 8 n'existe plus, et il n'est bien entendu plus relié au point milieu 7. Le point milieu 7 est par ailleurs connecté à une masse électrique 9 du système. Les condensateurs 5 et 6 sont en série entre un noeud haute tension 10 et un noeud basse tension 11. Dans l'exemple cité le noeud 10 est porté à + 200 volts par rapport à la masse 9, alors que le noeud 11 à - 200 volts.

Un moteur 12 triphasé comporte dans un exemple trois enroulements primaires 13 à 15 montés en série les uns avec les autres par l'intermédiaire de bornes de connexion 16 à 18. Les bornes 16 à 18 sont alimentées électriquement comme on le verra par la suite par un circuit 19 de commutation. Le circuit 19 est lui-même commandé par un circuit de traitement 20. Le circuit de traitement 20, dans un exemple préféré d'utilisation peut-être alimenté à partir du circuit de redressement 3 de telle façon que cet ensemble forme un dispositif compact qu'il est facile de placer contre le moteur 12. Le moteur 12 comporte enfin un rotor 21 avec des bobinages correspondants pour entraîner en rotation des charges mécaniques.

Le circuit 19 comporte de manière schématique trois cellules connectées en parallèle les unes des autres entre les bornes 10 et 11. Chaque cellule comporte deux transistors en série et reliés entre eux par un point milieu. Les point milieux, respectivement 22 à 24 de chaque cellule, sont connectés aux bornes 16 à 18. Les six transistors des trois cellules reçoivent sur leur grille de commande des signaux de commande produits par le circuit 20. Ces signaux de commande sont des signaux, dans l'exemple qui va être décrit, modulés en largeur.

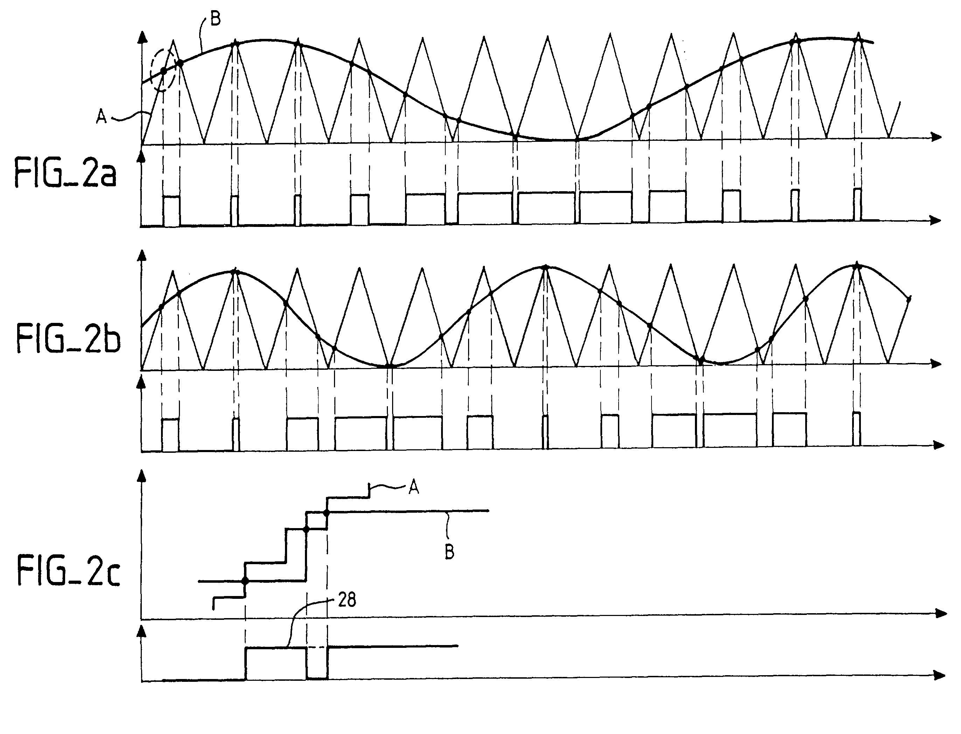

Les figures 2a à 2c montrent dans un exemple des particularités de production et d'utilisation de signaux de commandes modulés en largeur. La figure 2a montre le principe de cette production. On produit avec un premier générateur de signal un signal A en dent de scie. On verra que la forme en dent de scie est une forme préférée néanmoins d'autres formes seraient également utilisables avec des effets différents en ce qui concerne le résultat du traitement. On produit également avec un autre générateur de signal un signal B. Dans l'exemple préféré le signal B est un signal sinusoïdal. On fait en sorte que l'amplitude crête à crête des signaux A et B soit la même. Les fréquences des signaux A et B sont très sensiblement différentes. Dans un exemple la fréquence du signal A sera de l'ordre de 10 kilohertz alors que la fréquence du signal B sera de l'ordre de 200 hertz. D'autres valeurs sont également envisageables, le rapport pouvant être réduit et les fréquences être proches l'une de l'autre mais avec, comme on le verra par la suite, des problèmes supplémentaires qui naîtront.

Dans un circuit de comparaison 27, on compare en permanence la valeur du signal A à la valeur du signal B et on décide de produire une impulsion, montrée à la partie inférieure de la figure 2a, lorsque le signal A est supérieur au signal B. On aurait pu tout aussi bien prendre l'inverse.

Comme cela est apparent sur la figure on constate que les impulsions produites de cette façon sont de durée courte lorsque le signal B est à son maximum et sont de durée longue lorsqu'il est à son minimum. On obtient donc de cette façon, une modulation, dite en largeur, des impulsions produites.

Le circuit 20 comporte, pour simplifier, trois circuits de ce type. Chacun de ces circuits est donc capable de produire un signal comme celui représenté sur la figure 2a. Le circuit 20 comporte par ailleurs des circuits inverseurs pour produire des signaux complémentaires des trois signaux ainsi produits. Les six signaux résultants sont appliqués sur les trois cellules du circuit 19. Un signal étant appliqué sur un transistor d'une cellule alors que le signal complémentaire de ce signal est appliqué sur l'autre transistor de la même cellule. Il est connu dans l'état de la technique que cette manière d'agir permet, en déphasant les uns par rapport aux autres les signaux appliqués aux différentes cellules, d'alimenter de manière impulsionnelle les bornes 16 à 18 avec des tensions alternatives entre + 200 volts et - 200 volts. Le déphasage conduit à l'alimentation triphasée du moteur 12.

La production des signaux A et B dans le circuit 20 est effectuée en général par des lectures cycliques de tables 25,26 comportant des jeux de valeurs mémorisées en mémoire. Il peut y avoir plusieurs jeux de tables. A chaque temps de cycle d'une horloge cadencée à une fréquence f₁ ou f₀ respectivement, on lit une nouvelle valeur de la table à une adresse d'un mot. L'adresse augmente progressivement d'un temps de cycle à l'autre. Lorsqu'on arrive en lecture d'un dernier mot de la table on reboucle sur le premier mot, et ainsi de suite. Dans un exemple préféré la table 25 servant à produire le signal B comportera 48 valeurs et la table 26 servant à produire le signal en dent de scie A comportera 256 valeurs.

En pratique, plutôt que de revenir à une adresse initiale de lecture lorsqu'on a atteint l'adresse finale de lecture de la table, on peut continuer la lecture en faisant décroître les valeurs d'adresses de manière à lire la table à l'envers jusqu'à la valeur initiale. Puis on recommence à la lire à l'endroit et ainsi de suite. De ce fait, quand les signaux sont symétriques les tables peuvent être moins volumineuses.

Dans l'exemple préféré, la fréquence f₀ de lecture de la table produisant le signal A est de l'ordre de 10 Mégahertz, ce qui fait que la fréquence du signal A est de l'ordre de 10 kilohertz pour des questions de commutations. En effet, il faut lire 256 valeurs en montant et 256 valeurs en descendant, soit environ 500 valeurs, par période du signal A. De manière à ce que la distribution des impulsions du signal A pendant une période du signal B soit assez fine, on s'arrange pour que le nombre de ces impulsions du signal A soit de l'ordre de 50: 48 (qui est un multiple de deux) dans un cas préféré. Ceci conduit naturellement à une fréquence limite supérieure pour le signal B égale à 200 hertz (10.000/50 = 200). Compte tenu de ce qu'on cherche à créer des signaux déphasés de 120°, la table 25 est lue à chaque fois avec deux décalages pour lire à chaque fois trois valeurs à comparer à la valeur lue dans la table 26.

La figure 2b montre les mêmes éléments que la figure 2a avec seulement comme différence que dans la figure 2b la fréquence du signal B est plus grande que celle de la figure 2a.

Le mode de comparaison des signaux A et B dans le comparateur 27 n'est pas aussi simple qu'il paraît. La figure 2c montre ce qui peut survenir si l'instant de changement d'état du signal B n'est pas synchronisé avec les instants de changements d'états du signal A.

La figure 2c montre, en agrandissement, la partie de la figure 2a entourée par des tirets. Dans la figure 2c la croissance du signal A est plus rapide que la croissance du signal B du fait de la différence de fréquence évoquée ci-dessus. Plutôt que de n'avoir qu'un seul moment où le signal A devient supérieur au signal B, on constate cependant que, dans certains cas, le signal B peut être (pendant une durée très courte, de l'ordre de un ou deux temps de cycle à la fréquence f₀) inférieur au signal A, puis supérieur pendant encore un cycle avant de devenir inférieur à ce signal A pour une période plus longue. La présence d'impulsions parasites telles qu'une impulsion 28 montrée sur la figure 2c a conduit les hommes du métier à retenir pour ce type de circuit, entre autres, une synchronisation des signaux aux fréquences f₀ et f₁ de commande de lecture des tables 25 et 26.

Pour les moteurs synchrones triphasés, le seul moyen de changer la vitesse de rotation du moteur est de modifier la fréquence du signal B. Cependant, pour respecter les conditions de synchronisation imposés par les désordres décrits dans la figure 2c, on s'est imposé de synchroniser les signaux aux fréquences f₀ et f₁ qui permettent de produire les signaux A et B. En pratique ceci conduit à ce que f₁ soit un sous multiple de f₀. Ceci conduit à ce que la modification de la fréquence f₁ ne puisse évoluer que par des divisions par des entiers. Dans l'exemple choisi, on est ainsi capable de faire varier f₁ de 200 hertz à 100 hertz puis 66 hertz puis 50 hertz etc... Ces sauts en fréquence sont bien trop importants si on veut réguler la vitesse des moteurs d'une manière plus précise. En effet, si on s'arrange pour que le signal à 200 hertz conduise à une vitesse de moteur de l'ordre de 1000 tours par minute, le passage à 100 hertz conduit à modifier cette vitesse en une vitesse de 500 tours par minute, sans possibilité d'obtenir des vitesses intermédiaires à 825, à 790 tours par minute, etc...

Une des solutions envisagée à été de dupliquer la lecture de certains mots dans la table mémoire qui permet de produire le signal B. En lisant ainsi deux fois un même mot la période du signal B dure alors un temps de cycles de plus, 49 cycles au lieu de durer 48 cycles. Cette période se modifie d'environ 2%: c'est tout à fait acceptable pour le réglage. Le problème est cependant de choisir quels sont les mots mémoires de la mémoire qu'il faut lire à plusieurs reprise. En effet, si on se contente de lire à plusieurs reprises les premiers mots de la table (ceux dont l'adresse est proche du début de la table), on provoque une distorsion du signal alternatif équivalent produit pour le signal B. Cette distorsion conduit à des avances et des retards de phases de l'alimentation des enroulements 13 à 15 qui sont en définitive très mal supportés par le moteur 12. Ils conduisent à une usure irrégulière de ses paliers de rotation. Par ailleurs ces distorsions retentissent en des parasites électriques réinjectés sur le réseau 1.

On sait cependant répartir les adresses des mots à lire à plusieurs reprise parmi les adresses possibles des mots de la mémoire 25. Cependant cette répartition implique l'utilisation d'un microprocesseur et d'un microprogramme enregistré dont la puissance, et donc le coût, sont sans rapport avec le coût attendu du moteur 12 et de son circuit électronique de commande. En effet pour les moteurs à usage domestique le coût du moteur bobinage et circuit de commande ne devrait pas dépasser quelques francs. Il est donc impossible de commander un tel moteur avec un circuit à microprocesseur dont le coût est supérieur à plusieurs dizaines de francs.

L'invention va permettre de résoudre ce problème de faisabilité à moindre coût avec un circuit de commande, en pratique un circuit intégré simple, possédant peu de fonctions et donc particulièrement bon marché. Le principe de l'invention consiste à remarquer que les adresses des mots à lire dans la table 25 possèdent des poids faibles et des poids forts. Au fur et à mesure que ces adresses sont produites les poids faibles oscillent entre des valeurs 0 et 1, alors que les poids forts restent pendant une longue période dans un état avant de basculer pendant une longue période également dans l'autre état. L'idée de l'invention consiste alors à ne lire deux fois que les mots mémoire dont l'inverse des adresses est inférieur à un nombre donné. Par inverse des adresses on entend non pas l'adresse complémentaire mais l'adresse dans laquelle les moments de poids fort sont les moments de poids faible de l'adresse de départ et vice-versa. En pratique avec des adresses de n bits la position des n bits est inversée. Ce faisant en considérant alors cette adresse inversée comme un nombre et en comparant ce nombre à un seuil donné, on est sûr de répartir les adresses à lire deux fois de façon sensiblement égale dans les alternances positives et dans les alternances négatives du signal B.

L'invention a donc pour objet un circuit de production d'impulsions, notamment d'impulsions modulées en largeur, comportant
- un générateur d'adresses pour élaborer des signaux d'adresse,
- une mémoire dont les mots mémoires situés à des adresses produites par le générateur d'adresses sont lus à des instants répétés cycliquement, pour former un premier générateur de signal numérique,
- un circuit de traitement relié à cette mémoire pour produire en correspondance les dites impulsions,
caractérisé en ce que le générateur d'adresses comporte
- un circuit inverseur d'adresse pour inverser la position des éléments binaires des adresses de mots lus dans la mémoire,
- un comparateur relié au circuit inverseur pour comparer ces adresses inversées à une valeur prédéterminée et produire un signal de comparaison, et
- un circuit distributeur pour délivrer, en fonction de ce signal de comparaison, un signal de maintien d'une adresse élaborée pendant un instant suivant cet instant donné.

L'invention sera mieux comprise à la lecture de la description qui suit et à l'examen des figures qui l'accompagnent. Celles-ci ne sont données qu'à titre indicatif et nullement limitatif de l'invention. Les figures montrent:
Figure 1 à figure 2c: des représentations déjà commentées d'un système de l'état de la technique dans lequel l'invention peut être utilisée;
Figure 3: une représentation schématique du circuit de production d'impulsion selon l'invention;
Figure 4: les modification comparées de la forme du signal B selon l'état de la technique d'une part et selon l'invention d'autre part.

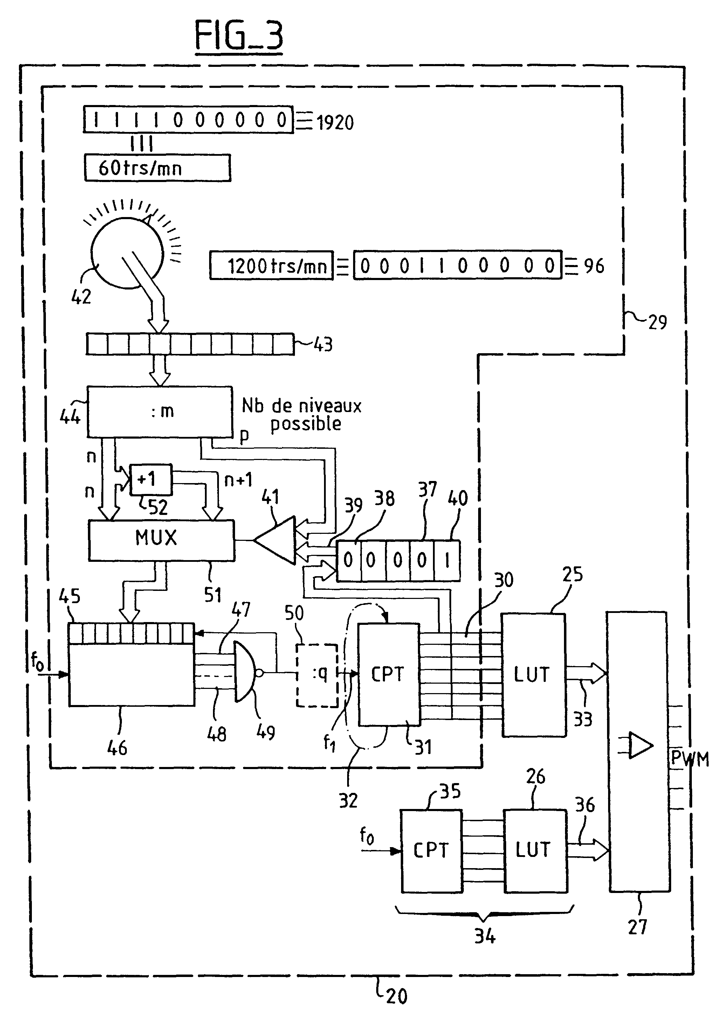

La figure 3 montre un circuit de production d'impulsions selon l'invention. Ce circuit comporte un générateur 29 d'adresses et une mémoire 25. La mémoire 25 possède des mots mémoire situés à des adresses. On peut accéder à ces mots mémoire au moyen d'un décodeur, non représenté, connecté à un bus d'adresses 30 sur lequel sont véhiculés les signaux d'adresses produit par le générateur 29. Le générateur 29 comporte un moyen pour relire cycliquement des mêmes mots dans la mémoire 25. Ceci est représenté schématiquement par un compteur d'adresses 31 du générateur 29 muni d'une boucle symbolique 32 montrant que le comptage est repris dès que le compteur a atteint la limite de comptage. Par limite de comptage on entend également le fait que, une fois que le compteur 31 a fini de compter, il pourrait se mettre à décompter, pour ensuite recommencer à compter une fois qu'il aurait aboutit à l'autre extrémité.

Lorsque la mémoire 25 reçoit des signaux d'adresses, son circuit de lecture délivre sur un bus de données 33 de cette mémoire des états électriques représentatifs des mots mémoires lus. Ces états électriques représentent des signaux numériques. La mémoire 25 fait ainsi partie d'un générateur de signal numérique.

Le circuit de production d'impulsion de l'invention comporte également ici, dans l'exemple préféré, un deuxième générateur de signal numérique 34. Dans l'exemple représenté ce deuxième générateur de signal numérique est constitué également avec un compteur 35 dont les sorties sont reliées aux entrées d'adresses d'une mémoire 26. La sortie de la mémoire 26 est connectée à un bus de données 36. On aurait pu réaliser le circuit 34 d'une autre manière: on aurait par exemple pu prendre un générateur de signaux analogiques périodiques suivi d'un convertisseur analogique numérique. Les mémoires 25 et 26 sont du type mémoire morte: elles permettent le transcodage des signaux d'adresse. Elles sont du type Look Up Table (LUT) en littérature anglo-saxonne.

Les deux bus de données 33 et 36 sont reliés à un circuit de traitement 27 de type connu et capable de produire les signaux impulsionnels représentés dans les parties inférieures des figures 2a et 2b quand il reçoit des signaux numériques B et A sur ses bus d'entrées 33 et 36 respectivement.

La caractéristique essentielle de l'invention est que le circuit de production comporte un inverseur 37 d'adresse pour inverser les adresses des mots lus dans la mémoire 25. Ce circuit d'inversion d'adresse peut dans un cas simple être un registre 37 connecté au bus 30 en sortie du compteur d'adresse 31, et recevant dans ses cellules les états électriques disponibles en sortie de ce compteur 31 et représentatifs de l'adresse.

Le registre 37 est dit inverseur parce qu'il va être lu d'une manière inverse de la manière dont il est écrit. Par exemple une cellule 38 est destinée à recevoir un bit de poids fort du signal d'adresse délivré par le bus 30. Elle sera lue pour produire un signal d'adresse de poids faible sur un bus 39 de lecture du registre 37. De la même façon une cellule 40 du registre 37, destinée à recevoir un bit de poids faible du signal d'adresse sera lue comme produisant un état électrique de poids fort sur le bus d'adresse 39. Le registre 37 est relié par le bus 39 à un comparateur 41 qui reçoit par ailleurs une valeur numérique binaire, p, de comparaison.

Le comparateur 41 est un comparateur qui compare la valeur binaire d'un signal p à la valeur binaire représentée par le signal d'adresse transmis par le bus 39. Le comparateur 41 comporte un jeu de comparateurs pour comparer des bits correspondants, et un circuit logique pour délivrer un état en fonction du rang le plus fort des bits présentés à ces entrées et qui sont différents.

La sortie du circuit comparateur 41 est reliée à un circuit dit distributeur dont le rôle est d'augmenter la durée pendant laquelle l'adresse délivrée par le compteur 31 est maintenue à la valeur qui vient d'être produite. Le circuit est dit distributeur car il distribue régulièrement, parmi les adresses des mots de la mémoire, celles qui doivent provoquer un tel maintien. De ce fait le circuit distributeur délivre un signal de maintien, en sortie du compteur 31, de l'adresse préalablement élaborée pendant un instant qui suit celui au cours duquel cette adresse a été élaborée. Ce maintien étant fondamental, bien qu'on a présenté l'invention dans le cadre d'une utilisation avec la production de signaux impulsionnels modulés en largeur, avec un comparateur qui compare les signaux produits par la mémoire 25 à ceux produit par une mémoire 26, on peut comprendre que l'invention concerne essentiellement la production sur le bus 33 d'un signal de forme donnée mais dont la fréquence évolue. On a ainsi formé un générateur à fréquence variable.

Le circuit distributeur va être maintenant détaillé dans le cadre de l'application envisagée. En imaginant que le moteur 12 est le moteur d'une machine à laver domestique, on va par exemple vouloir au moyen d'un bouton de commande 42 régler la vitesse du moteur d'essorage de cette machine, petit à petit, entre une vitesse maximale de 1200 tours par minute et une vitesse minimale de, par exemple, 60 tours par minute. Le bouton 42 est associé à un circuit électronique capable de produire un mot binaire représentatif par sa valeur de l'inverse de la vitesse. Ce circuit électronique comporterait par exemple un potentiomètre dont le curseur serait relié à un circuit convertisseur analogique numérique. Pour la simplification de l'explication on admettra que le signal numérique codé sur 10 bits pour représenter 1200 tours par minute est équivalent à 96 en binaire. Pour la valeur minimale de 60 tours par minute, on admettra que le signal binaire produit est équivalent à 1920 en binaire.

Ce signal est chargé par le circuit électronique du bouton de commande 42 dans un registre 43. Ce qu'on met dans le registre 43 peut aussi provenir d'une consigne présente dans une boucle de contre réaction régulant la vitesse du moteur. Le contenu de ce registre 43 est ensuite divisé par un diviseur 44 par m. Le nombre m représente le nombre de mots mémoire de la mémoire 25. Dans l'exemple m vaut 48. Le résultat de la division par m est un quotient n avec un reste p. Le quotient n est chargé dans un registre 45 de précharge d'un compteur 46 qui reçoit sur son entrée de comptage le signal d'horloge à la fréquence f₀. Le compteur 46 est en fait un compteur décompteur possédant une entrée de forçage pour se mettre dans un état prédéterminé au début du décomptage. L'entrée de forçage reçoit le contenu du registre 45 au début du décomptage. Plus le contenu du registre 45 est élevé, moins le compteur décompteur 46 arrivera vite à son état zéro 00...0 (où on recommence le décomptage). Ceci est la raison pour laquelle le circuit électronique associé au bouton 42 inverse les valeurs binaires par rapport aux valeurs affichées en tours par minute.

Les sorties 47 à 48 du compteur 46 sont reliées à une porte NON ET 49 dont la sortie passe temporairement par l'état 1 au moment où le compteur 46 arrive à l'état 00...0. A ce moment le signal disponible en sortie de la porte 49 est utilisé pour réinitialiser le décomptage du compteur 46. La fréquence d'apparition des impulsions à la sortie de la porte 49 est d'autant plus grande, pour une fréquence f₀ donnée, que la valeur binaire chargée dans le registre 45 est faible (que donc le nombre de tours par minute est élevé). Les impulsions disponibles en sortie de la porte 49 sont divisées éventuellement par un diviseur 50 effectuant une division par une valeur q. Le signal délivré par le diviseur 50 oscille à la fréquence f₁. Dans un exemple q vaut de l'ordre de 1000. Cette division n'est pas du tout indispensable, elle est liée tout simplement à la valeur de la fréquence f₀ comparée à la valeur f₁ résultante. En choisissant une valeur f₀ plus faible le diviseur 50 peut être évité. Les impulsions délivrées par le diviseur 50 sont introduites sur l'entrée de comptage du compteur 31 qui effectue le comptage et l'adressage de la mémoire 25 évoquée précédemment.

Dans le cas de la vitesse maximale, 1200 tours par minute, où le nombre binaire du registre 43 vaut 96, et où la valeur de m vaut 48 parce qu'il y a 48 valeurs enregistrées dans la mémoire 25 à 48 mots d'adresse, la division par le diviseur 44 donne un quotient n égal à deux et un reste p égal à zéro. L'adressage se produit donc comme indiqué ci-dessus. Par contre, si on modifie la position du bouton 42, très légèrement, la valeur chargée dans le registre 43 va augmenter (en équivalent binaire de 96 à 1920). Si la valeur passe à 97, le reste p vaudra 1. On notera d'ailleurs que p est toujours inférieur à m. La valeur p représente en fait le nombre de mots mémoire de la mémoire 25 qu'il faut lire, ou plutôt utiliser, pendant un temps de cycle supplémentaire, pour allonger la période du signal B en fonction du besoin.

Comme indiqué précédemment p représente le nombre de mots mémoire qu'il faut lire plus souvent, mais il ne permet pas, avant l'invention, de connaître directement quels sont les mots mémoire de la mémoire 25 qu'il faut lire pour conduire un signal B qui ne soit pas distordu, au moins pas trop. Le signal p valant 1, seule l'adresse 000...0 débitée par le compteur 31 est inférieure à p. Donc l'inverse de cette adresse (qui est dans ce cas particulier une adresse située au même endroit qu'elle-même) est inférieure à 1. Cette adresse inverse comparée à la valeur p=1 par le comparateur 41 conduit à la désignation de cette adresse inverse 000 ...0 pour un mot qui doit être utilisé plus longtemps.

Dans ce cas, le comparateur 41 émet un signal de commande qui agit sur un multiplexeur 51. Le multiplexeur 51 permet, selon la valeur de son signal de commande, le chargement du registre 45 avec la valeur n ou avec la valeur n+1. La valeur n correspond à une transmission directe depuis la sortie du diviseur 44, alors que la valeur n+1 est obtenue par un additionneur 52 qui ajoute la valeur +1 à la valeur lue en sortie du diviseur 44. Pour la valeur 96 évoquée précédemment et avec m égal à 48, n valait 2: en binaire cela s'écrit 10. La valeur n+1 s'écrit alors 11 en binaire.

Autrement dit, au moment du début du comptage, lorsque l'adresse initiale débitée par le compteur 31 vaut 00...0, le comparateur 41 délivre un signal tel que la valeur 11 est chargée dans le registre 45. Dans ce cas, il faut un cycle de l'horloge f₀ en plus avant que la porte 49 ne délivre une impulsion supplémentaire. Compte tenu du diviseur par q, pour les q-1 impulsions suivantes délivrées par la porte 49, elles ne sont délivrées qu'au bout de 3 (11 en binaire) temps de cycles de f₀ au lieu de 2 (10) temps de cycle. Si le diviseur par q n'est pas présent, c'est le mot suivant de la mémoire 25 qui va être utilisé un temps de cycle de plus. La répartition sera quand même régulière.

A l'adresse suivante qui est 00...10, le comparateur 41 ne détecte plus que l'inverse de l'adresse est inférieur à p. En effet, il est alors un nombre très grand puisque, dans ses bits de poids fort, ce nombre inverse d'adresse possède un bit à 1. Dans ce cas le multiplexeur 51 transmet l'état n au registre 45. Jusqu'à ce que le compteur 31 ait fini son tour les valeurs d'adresse qu'il délivre seront maintenues deux q fois le temps de cycle de f₀, la première adresse ayant elle été maintenue trois q fois.

Si au lieu de 96 on lit 98, le reste de la division par le diviseur 44 sera p=2. Dans ce cas comme dans le précédent l'adresse 00...0 sera maintenue trois q fois, et l'adresse 000...1 ne sera maintenue que deux q fois. L'autre adresse qui sera maintenue trois q fois le temps de cycle est l'adresse dont le bit de poids le plus fort vaut 1 tous les autres bits valant zéro. C'est cette représentation qui est montrée sur la figure 3 où la cellule 40 possède un bit à 1, les autres étant des bits à 0. Ainsi de suite selon la valeur de p le comparateur 41 choisit ceux des mots qui doivent être utilisés un temps de cycle supplémentaire.

Avec un choix de 64 valeurs pour la mémoire 25, et avec m=64, il suffirait de réaliser un compteur 31 à 6 bits et le phénomène se passerait exactement comme décrit jusqu'ici. Cependant pour des raisons de taille mémoire on a retenu m=48 qui n'est pas une puissance entière de deux. On se rend compte qu'il faut alors éliminer certains résultats de comptage délivrés par le compteur 31. On en élimine un quart de façon à passer de 64 à 48. Une telle élimination peut être obtenue en détectant les occurrences de l'état 10 sur les bits de poids faibles du compteur 31. Ces occurrences sont détectées par deux portes OU Exclusif recevant chacune un de ces bits de poids faible et la valeur 1 ou 0 respectivement. Ces deux portes OU Exclusif sont reliées à une porte ET qui passe en définitive a un au moment où une telle occurrence est détectée. On provoque alors un comptage complémentaire rapide du compteur 31 pour qu'il passe de l'état 10 (poids faible) à l'état 00 (poids faible) sans être passé par l'état 11. Des circuits effectuant ce type de comptage sont déjà connus dans l'état de la technique. On modifie par ailleurs en conséquence le décodeur d'accès à la mémoire 25. Des bits de poids faibles 11 n'y permettent pas d'adressage, les circuits correspondant sont supprimés.

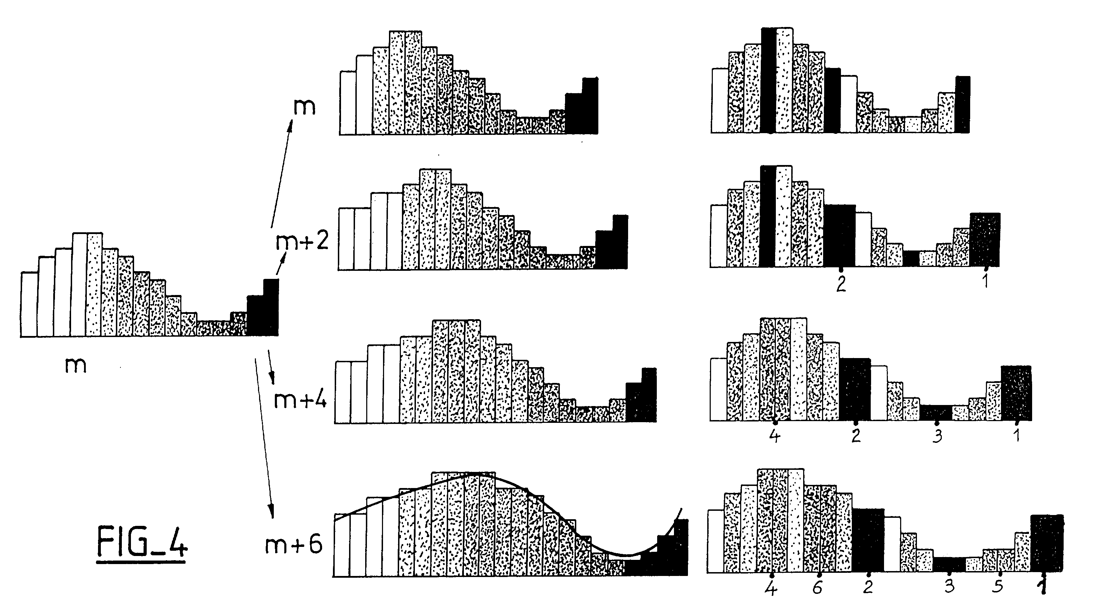

La figure 4 montre d'une manière comparative la déformation apportée au signal B respectivement par un circuit de l'état de la technique et par celui de l'invention. On a montré quatre situations dans lesquelles un signal B évoluant pendant m temps de cycles devrait voir sa fréquence baisser pour être répartie sur m+2, m+4, m+6 temps de cycles etc. Dans l'état de la technique, qui revient à comparer directement les adresses lues à la valeur p, on est conduit à maintenir le signal délivré par la mémoire 25 pendant les impulsions se produisant au début de la lecture de la mémoire 25. On notera qu'on appelle début de la lecture de la mémoire une valeur quelconque de la mémoire 25 caractérisée par son adresse 00...0 dans la table 25. Le bas de la figure 4, au centre, montre que pour m+6 il apparait une très grande distorsion entre l'alternance positive dont la partie montante est très lente et l'alternance négative dont la partie montante est raide. Le signal est le plus déformé lorsque p et de l'ordre de m/2.

A l'opposé dans l'invention, avec le système décrit on voit que selon que p vaut de 2 à 6 les adresses des mots mémoires lus dans la mémoire 25 se repartissent naturellement harmonieusement de telle façon que l'alternance positive reste sensiblement de même durée que l'alternance négative, et que la déformation apportée à l'une soit compensée par une déformation symétrique apportée à l'autre.

Avec le circuit de l'invention on obtient donc une forme maintenue dans des tolérances tout à fait acceptables, et ce au prix d'un circuit supplémentaire très simple qui ne comporte en pratique que le circuit inverseur d'adresse 37 (seulement un registre), le comparateur 41 et le multiplexeur 51. En effet les diviseurs 44, compteur 46 et 31 sont naturellement déjà disponibles dans de nombreux circuits de commande. La modification apportée ici est donc très simple: le coût impliqué est minime.

## Revendications

1. Circuit de production d'impulsions, notamment d'impulsions modulées en largeur, comportant
- un générateur d'adresses (29) pour élaborer des signaux d'adresse,
- une mémoire (25) dont les mots mémoires situés à des adresses produites par le générateur d'adresses sont lus à des instants répétés cycliquement, pour former un premier générateur de signal numérique,
- un circuit de traitement (27) relié à cette mémoire pour produire en correspondance les dites impulsions,
caractérisé en ce que le générateur d'adresses (29) comporte
- un circuit (37) inverseur d'adresse pour inverser la position des éléments binaires des adresses de mots lus dans la mémoire,
- un comparateur (41) relié au circuit inverseur pour comparer ces adresses inversées à une valeur prédéterminée (p) et produire un signal de comparaison, et
- un circuit distributeur (45-51, 31) pour délivrer, en fonction de ce signal de comparaison, un signal de maintien d'une adresse élaborée pendant un instant suivant cet instant donné.

2. Circuit selon la revendication 1, caractérisé en ce que
- il comporte un deuxième générateur de signal numérique (34),
- le circuit de traitement (27) comporte un comparateur pour comparer les signaux numériques produits à un instant donné par ce premier et ce deuxième générateur de signaux numériques et un circuit logique pour produire en correspondance les dites impulsions.

3. Circuit selon l'une des revendications 1 ou 2, caractérisé en ce que le circuit distributeur comporte
- un compteur d'adresse (45-50, 31), et
- un multiplexeur (51) commandé par le signal de comparaison et recevant un premier et un deuxième signal de consigne, pour transmettre un de ces signaux de consigne à ce compteur d'adresse.

4. Circuit selon la revendication 3, caractérisé en ce que le compteur d'adresse comporte
- un premier compteur-décompteur (46) recevant un signal d'horloge (f₀) sur une entrée de décomptage, le signal délivré par le multiplexeur (51) sur une entrée de préchargement, et délivrant un signal modulé dans le temps en fonction du signal de comparaison.

5. Circuit selon la revendication 4, caractérisé en ce que le compteur d'adresse comporte
- un deuxième compteur (31) monté en comptage cyclique en aval du premier compteur, recevant en entrée le signal de sortie (f₁) du premier compteur et délivrant en sortie les adresses du générateur d'adresses.

6. Circuit selon la revendication 5, caractérisé en ce que le compteur d'adresse comporte
- un circuit diviseur (50) interposé entre le premier et le deuxième compteur.

7. Circuit de commande d'un appareil avec des impulsions modulées en largeur caractérisé en ce qu'il comporte un circuit de commutation recevant des impulsions qui sont modulées en largeur par un circuit selon l'une des revendications 1 à 6.

## Patentansprüche

1. Schaltkreis zur Erzeugung von Pulsen, insbesondere Pulsen mit modulierter Breite, der umfaßt:
einen Adressengenerator (29) zum Erzeugen von Adreßsignalen,
einen Speicher (25), dessen Speicherworte an den durch den Adressengenerator erzeugten Adressen zu sich zyklisch wiederholenden Zeitpunkten gelesen werden, so daß er einen ersten numerischen Signalgenerator bildet,
einen Verarbeitungsschaltkreis (27), der mit diesem Speicher verbunden ist, um entsprechend die Pulse zu erzeugen,
dadurch **gekennzeichnet,** daß
der Adressengenerator (29) umfaßt:
einen Adresseninverterschaltkreis (37) zum Invertieren die Position der binären Elemente der Adressen der Worte, die in dem Speicher gelesen werden,
einen Vergleicher (41), der mit dem Inverterschaltkreis verbunden ist, um diese invertierten Adressen mit einem vorgegebenen Wert (p) zu vergleichen und ein Vergleichssignal zu erzeugen, und
einen Verteilerschaltkreis (45-51, 31), um in Abhängigkeit von diesem Vergleichssignal ein Haltesignal für eine Adresse auszugeben, die während eines Zeitpunktes nach dem gegebenen Zeitpunkt erzeugt worden ist.

2. Schaltkreis nach Anspruch 1,
dadurch gekennzeichnet, daß:
er einen zweiten numerischen Signalgenerator (34) umfaßt,
der Verarbeitungsschaltkreis (27) einen Vergleicher umfaßt, um die numerischen Signale, die zu einem gegebenen Zeitpunkt durch den ersten und den zweiten numerischen Signalgenerator erzeugt worden sind, zu vergleichen, und einen Logikschaltkreis umfaßt, um entsprechend die Pulse zu erzeugen.

3. Schaltkreis nach einem der Ansprüche 1 oder 2,
dadurch gekennzeichnet, daß
der Verteilerschaltkreis umfaßt:
einen Adressenzähler (45-50, 31) und
einen Multiplexer (51), der durch das Vergleichssignal gesteuert wird und ein erstes und zweites Stellsignal empfängt, um eines dieser Stellsignale an den Adressenzähler zu übertragen.

4. Schaltkreis nach Anspruch 3,
dadurch gekennzeichnet, daß
der Adressenzähler umfaßt:
einen ersten Aufwärts-Abwärts-Zähler (46), der ein Taktsignal (f₀) an einem Abwärtszählereingang empfängt, wobei das Signal durch den Multiplexer (51) an einen Eingang zur Voreinstellung ausgegeben wird, und der ein zeitlich moduliertes Signal in Abhängigkeit von dem Vergleichssignal ausgibt.

5. Schaltkreis nach Anspruch 4,
dadurch gekennzeichnet, daß
der Adressenzähler umfaßt:
einen zweiten Zähler (31), der zum zyklischen Zählen nach dem ersten Zähler angeordnet ist und am Eingang das Ausgangssignal (f₁) des ersten Zählers empfängt und am Ausgang die Adressen des Adressengenerators ausgibt.

6. Schaltkreis nach Anspruch 5,
dadurch gekennzeichnet, daß
der Adressenzähler umfaßt:
einen Teilerschaltkreis (50) zwischen dem ersten und dem zweiten Zähler.

7. Steuerschaltkreis eines Gerätes mit breitenmodulierten Pulsen,
dadurch gekennzeichnet, daß
er einen Umschaltschaltkreis umfaßt, der Pulse empfängt, die durch einen Schaltkreis nach einem der Ansprüche 1 bis 6 breitenmoduliert sind.

## Claims

1. Circuit for generating pulses, notably width-modulated pulses, including
- an address generator (29) for producing address signals,
- a memory (25) whose memory words situated at addresses produced by the address generator are read at cyclically repeated instants, to form a first digital signal generator,
- a processing circuit (27) connected to this memory in order to produce the said pulses in correspondence,
characterised in that the address generator (29) includes
- an address reversing circuit (37) for reversing the position of the binary elements of the addresses of words read in the memory,
- a comparator (41) connected to the reversing circuit for comparing these reversed addresses with a predetermined value (p) and producing a comparison signal, and
- a distribution circuit (45-51, 31) for delivering, as a function of this comparison signal, a signal for maintaining an address produced for an instant following this given instant.

2. Circuit according to Claim 1, characterised in that
- it includes a second digital signal generator (34),
- the processing circuit (27) includes a comparator for comparing the digital signals produced at a given instant by these first and second digital signal generators and a logic circuit for producing the said pulses in correspondence.

3. Circuit according to one of Claims 1 or 2, characterised in that the distribution circuit includes
- an address counter (45-50, 31), and
- a multiplexer (51) controlled by the comparison signal and receiving first and second reference signals, in order to transmit one of these reference signals to this address counter.

4. Circuit according to Claim 3, characterised in that the address counter includes
- a first counter/downcounter (46) receiving a clock signal (f₀) at a downcounting input, the signal delivered by the multiplexer (51) at a preloading input, and delivering a time-modulated signal as a function of the comparison signal.

5. Circuit according to Claim 4, characterised in that the address counter includes
- a second counter (31) connected for cyclical counting downstream of the first counter, receiving as an input the output signal (f₁) of the first counter and delivering as an output the addresses of the address generator.

6. Circuit according to Claim 5, characterised in that the address counter includes
- a dividing circuit (50) interposed between the first and second counter.

7. Circuit for controlling an appliance with width-modulated pulses, characterised in that it includes a switching circuit receiving pulses which are width-modulated by a circuit according to one of Claims 1 to 6.
